# EUROPEAN PATENT SPECIFICATION

(11) **EP 1 801 145 B1**
(45) Date of publication and mention of the grant of the patent: **19.11.2008**
(21) Application number: 04792167.1
(22) Date of filing: 07.10.2004
(51) Int. Cl.: C08J 5/18, B41N 1/12, G03F 7/004, C08L 101/00

(54) **PROCESS FOR PRODUCING CURED PRODUCT OF PHOTOSENSITIVE RESIN**
VERFAHREN ZUR HERSTELLUNG EINES GEHÄRTETEN PRODUKTS AUS LICHTEMPFINDLICHEM HARZ
PROCEDE SERVANT A PRODUIRE UN PRODUIT DURCI DE RESINE PHOTOSENSIBLE

(30) Priority: 13.09.2004 JP 2004265446
(43) Date of publication of application: 27.06.2007
(73) Proprietor: Asahi Kasei Chemicals Corporation, Tokyo 100-8440 (JP)
(72) Inventor: TOMITA, Yoko, Fuji-shi, Shizuoka 416-0909 (JP); TOMEBA, Kei, Kurieitohaitsu 103, Fuji-shi, Shizuoka 416-0939 (JP); YAMADA, Hiroshi, Mishima-shi, Shizuoka 411-0031 (JP)
(74) Representative: Bradley, Josephine Mary
(86) International application number: PCT/JP2004/014870
(87) International publication number: WO 2006/030537

(56) References cited:
- EP-A1- 1 120 447
- EP-A1- 1 388 578
- JP-A- 6 123 966
- JP-A- 7 505 840
- JP-A- 10 120 982
- JP-A- 2002 275 392
- JP-A- 2002 356 505
- JP-A- 2003 026 715
- JP-A- 2004 174 758

## Description

### TECHNICAL FIELD

The present invention relates to a process for producing a photosensitive resin composition which can be cured by irradiating with light in air and a cured product of a photosensitive resin.

### BACKGROUND ART

If a photosensitive resin composition layer is formed onto a sheet-like or cylindrical support using a liquid photosensitive resin composition as a radical polymerization system and then subjected to crosslinking/curing induced by light in air, the curing in the surface vicinity inadequately occurs. So, the surface tack is large and is easily damaged. As a result, this means causes a problem in terms of ensuring plate thickness accuracy. As disclosed in JP-A-11-258790 (Patent Document 1), the reason why the above curing in the surface vicinity inadequately occurs is thought to be as a result of inhibition of curing caused by oxygen. Therefore, in conventional techniques liquid photosensitive resin compositions have been cured using methods such as covering with a cover film which has high light-transmittance onto the surface of the liquid photosensitive resin composition layer, photo-curing in an inert gas atmosphere, photo-curing in a vacuum or photo-curing in a water environment. However, in the case of using these methods, additional equipment is required for coating the photosensitive resin composition onto a support, forming the photosensitive resin composition layer, and then covering a cover film onto the surface, or for turning the exposing atmosphere into a vacuum, inert gas atmosphere (such as nitrogen) or water environment. As a result, the apparatus used to photo-cure the liquid photosensitive resin composition becomes complicated. Accordingly, there is a need for a liquid photosensitive resin composition which is capable of thick-film curing in air.

Further, while JP-A-56-64823 (Patent Document 2) discloses a method for forming a cylindrical photosensitive resin cured product layer using a liquid photosensitive resin composition, this document does not describe the specific photosensitive resin composition.
One example of a method for producing a roll by photo-curing a liquid photosensitive resin composition is carried out by positioning two rolls so as to have a fixed gap therebetween and filling a liquid photosensitive resin composition in between the two rolls. In this method, while rotating the two rolls each in an inner-side direction thereof, the liquid photosensitive resin composition is passed through the gap between the rolls, and thereby coated onto the rolls. Photo-curing is performed by irradiating light from a light source in the interior of a roll through a slit provided in the interior of the roll onto the liquid photosensitive resin composition, whereby the photosensitive resin composition is fixed onto the other roll. In this method, the liquid photosensitive resin composition is sandwiched by two rolls, so that the photosensitive resin composition of the portion that is sandwiched by the rolls is photo-cured. The liquid photosensitive resin composition is photo-cured without coming into contact with air. Thus, this differs from a method which carries out photo-curing in air. In addition, since air is shut out, a highly specialized equipment is required in which a lamp is arranged in the interior of one of the rolls, and a slit is further arranged inside the roll, so that only the portion which is closest to the two rolls is photo-cured. Since one of the two rolls is required to transmit light, the roll must be made from a material which transmits the light from the lamp used, and the surface of the roll must be treated with a mold-release agent so that the photosensitive resin composition is formed only on the other roll.

Japanese Patent No. 2846954 (Patent Document 3) discloses hydrogen abstraction-type photopolymerization initiators as the photopolymerization initiator for a photosensitive solid plate consisting of a thermoplastic elastomer which is in the state of a solid at 20°C, specifically disclosing the combinations of anthraquinone and a hydrogen donor; benzophenone and a tertiary amine; benzophenone and a Michler's ketone; thioxanthones; and 3-ketocoumarins. However, this document neither teaches any surface curability in air nor any preferable combination of a hydrogen abstraction-type photopolymerization initiator and a disintegration-type photopolymerization initiator.

JP-A-10-95788 (Patent Document 4) or JP-A-10-29997 (Patent Document 5) describes the mixture of an acylphosphine oxide compound of a disintegration-type photopolymerization initiator with other types of photopolymerization initiator (for example, α-hydroxy ketones or α-amino ketones) of disintegration-type photopolymerization initiators, or with benzophenones of hydrogen abstraction-type photopolymerization initiators. However, these documents do not describe that the combination of a hydrogen abstraction-type photopolymerization initiator and a disintegration-type photopolymerization initiator is preferable. Also, these documents do not describe any curability in air. In addition, these documents do not describe any resin component used together with the photopolymerization initiator.

JP-A-8-59885 (Patent Document 6) describes a method for producing a sheet-like relief printing plate by irradiating light through an exposure mask so that the portions exposed to the light are cured, and then undergoing a developing step to form a pattern. This document describes that the combination of a benzoin alkyl ether carbonyl compound as a disintegration-type photopolymerization initiator and a benzophenone/amine compound as a hydrogen abstraction-type photopolymerization initiator can be used as a photosensitive resin composition. This document further states that an amine compound is an essential component for the hydrogen abstraction-type photopolymerization initiator. However,'in this document there is no description about exposing in air when photo-curing the liquid photosensitive resin composition to form the pattern. Indeed, in all of the Examples exposure is carried out in a state wherein oxygen is shut out by covering with a cover film. This document describes a curing method wherein a liquid photosensitive resin composition with a cover film formed thereover is cured by being exposed to light, the cured product is subjected to a developing step using a developing solution to form an uneven pattern, and then the adhesive component that adhered to the surface during the developing step is subjected to postexposure. Thus, since the photosensitive resin composition is covered with the cover film so that light is irradiated in a state of shutting out oxygen, this technical idea fundamentally differs from the method according to the present invention wherein a thick-film of a photosensitive resin composition is cured by light in air in that the portions irradiated with light are completely cured as far as the surface as well as in that an extremely thin adhesive component which adhered during the developing step to the completely cured surface is cured. In addition, in order to decrease surface tack Patent Document 6 discloses a complicated method which independently carries out the step of forming a pattern with light having a wavelength of 300 nm or more and the subsequent step, i.e. the post-treatment step of irradiating light having a wavelength of between 200 and 300 nm. It is believed that the reason why such complicated method is required is that this method is essentially needed to give a cover film onto the photosensitive resin composition layer surface. In other words, this is because light in the wavelength of between 200 nm and 300 nm cannot be efficiently transmitted since there are no general-purpose films which efficiently transmit light in the wavelength region of between 200 and 300 nm even if light having a wavelength of 200 nm or more is irradiated during the pattern forming exposure step. As disclosed in U.S. Patent 4,202,696 (Patent Document 7), it is well known to cover with a cover film and then independently carry out the step of forming the pattern by exposing and developing and the step of decreasing the surface tack of a cured product layer by impregnating the formed pattern surface with an organic carbonyl compound and then irradiating with light having a wavelength of between 200 and 300 nm. It is thus thought that Patent Document 6 uses this method.

The present inventors also attempted to photo-cure to a film thickness of about 3 mm thick by using the photosensitive resin composition disclosed in Patent Document 6. However, the surface vicinity could not be completely cured. For example, if touched with a finger, the finger print was transferred and the surface of the cured product was still very sticky. Accordingly, curability in the surface vicinity could hardly be said to be satisfactory;

In general, when patterning a liquid photosensitive resin composition using the photoengraving technique, the liquid photosensitive resin composition is brought into contact with the surface of an exposure mask. When the exposure mask may be contaminated with the resin, a cover film is covered onto the surface of the photosensitive resin composition layer. In each case the photosensitive resin composition layer surface is covered with a film, so that the exposure cannot be carried out in air. In the semiconductor production field, there is a proximity exposure method which avoids direct contact between the photosensitive resin composition and the exposure mask by providing a very narrow gap between the photosensitive resin composition and the exposure mask. However, the photosensitive resin composition used in this method is a solid state, and liquid photosensitive resin compositions are not normally employed. In the printing plate field a base material is typically used which has a much greater size than the silicon wafer used in the semiconductor field. Therefore, it is very difficult to control a narrow gap over a large surface area. Thus, it is difficult to employ the proximity exposure method. While it is possible to deal with this by setting the gap to be large, this would cause a substantial drop in the resolution of the patterns to be formed. In the meanwhile, in forming the cured product of a photosensitive resin according to the present invention, a uniform cured product layer has only to be formed by irradiating light over the entire photosensitive resin composition layer. In short, there is no need for a fine pattern formation. Therefore, the feature that an entire photosensitive resin composition layer can be photo-cured by irradiating light having a wavelength of 200 nm or more in a single pass in air without covering a cover film onto the liquid photosensitive resin composition layer is a fundamentally different technical concept from a process which forms a printing plate by patterning with a photoengraving technique. Furthermore, Patent Document 6 contains no disclosure regarding a photosensitive resin cured product obtained by photo-curing in air.

Patent Document 1: JP-A-11-258790
Patent Document 2: JP-A-56-64823
Patent Document 3: JP-B-2846954
Patent Document 4: JP-A-10-95788
Patent Document 5: JP-A-10-29997
Patent Document 6: JP-A-8-59885
Patent Document 7: US-B-4202696

### DISCLOSURE OF THE INVENTION

### PROBLEMS TO BE SOLVED BY THE INVENTION

It is an object of the present invention to provide a method for producing a photosensitive resin composition which can be cured by irradiating with light in air and a cured product of a photosensitive resin.

### MEANS FOR SOLVING THE PROBLEMS

The present inventors have found that the photosensitive resin composition layer on be cured by irradiating with light in air by forming a radical polymerization system liquid photosensitive resin composition layer which contains a hydrogen abstraction-type photopolymerization initiator and a disintegration-type photopolymerization initiator onto a sheet-like or cylindrical support, thereby arriving at the present invention. That is, the present inventors have found the surprising phenomenon that a radical polymerization system liquid photosensitive resin composition layer can be photocured deeply in air by using a resin having a specific functional group and the combination of a hydrogen abstraction-type photopolymerization initiator and a disintegration-type photopolymerization initiator or a resin having a specific functional group and a photopolymerization initiator which has in its molecule a site which functions as a hydrogen abstraction-type photopolymerization initiator and a site which functions as a disintegration-type photopolymerization initiator.

The present invention is as follows
(1) A process for producing a laser engravable and cylindrical printing base material including the steps of: forming a photosensitive resin composition layer of from 50 µm to 50 mm in thickness on a cylindrical support using a photosensitive resin composition which includes a hydrogen abstraction-type photopolymerization initiator (d) and a disintegration-type photopolymerization initiator (e) wherein the hydrogen abstraction-type photopolymerization initiator (d) is at least one kind of compound selected from the group consisting of benzophenones, Michler's ketones, xanthenes, thioxanthenes and anthraquinones, and the disintegration-type photopolymerization initiator (e) is at least one kind of compound selected from the group consisting of benzoin alkyl ethers, 2,2-dialkoxy-2-phenylacetophenones, acyloxime esters, azo compounds and diketones or a photo sensitive resin composition which includes a photopolymerization initiator (c) having in the same molecule a site which functions as a hydrogen abstraction-type photopolymerization initiator and a site which functions as a disintegration-type photopolymerization initiator; and curing by irradiating the photosensitive resin composition layer with light in air.
(2) The process for producing a laser engravable and cylindrical printing base material according to the above (1), wherein the photosensitive resin composition is a liquid state at 20°C.
(3) The process for producing a laser engravable and cylindrical printing base material according to the above (1) or (2), wherein the photosensitive resin composition layer is formed by coating the photosensitive resin composition onto a cylindrical support.

(4) Use of a laser engravable and cylindrical printing base material obtained according to any of the above (1) to (3), as a transfer roll (blanket roll) for transferring ink, an ink squeeze roll in contact with an anix roll for adjusting an ink supply, a roll used for laser engraving which can form an uneven pattern on a surface by laser engraving, or a cushion roll.

(5) A photosensitive resin composition for a laser engravable and cylindrical printing base material including a resin (a) having a number average molecular weight of from 1,000 or more to 200,000 or less, wherein the resin (a) includes in a molecule thereof either at least one kind of organic group selected from the group consisting of an aryl group, a straight or branched chain alkyl group substituted with at least one aryl group,
an alkoxycarbonyl group, a hydroxyl group and a formyl group or a bond of a carbonate bond or an ester bond; the organic group and the bond directly bind to a carbon atom; the carbon atom binds to hydrogen atom(s) (α-hydrogen atom(s)) of no less than 2% with respect to the total of hydrogen atoms in the molecule; an organic compound (b) having a number average molecular weight of from 1,000 or less and a polymerisable unsaturated group; and
a photopolymerisation initiator and wherein the photopolymerization initiator is a combination of a hydrogen abstraction-type photopolymerization initiator (d) and a disintegration-type photopolymerization initiator (e)wherein the hydrogen abstraction-type photopolymerization initiator (d) is at least one kind of compound selected from the group consisting of benzophenones, Michler's ketones, xanthenes, thioxanthenes and anthraquinones, and the disintegration-type photopolymerization initiator (e) is at least one kind of compound selected from the group consisting of benzoin alkyl ethers, 2,2-dialkoxy-2-phenylacetophenones, acyloxime esters, azo compounds and diketones, and further the hydrogen abstraction-type photopolymerization initiator (d) and the disintegration-type photopolymerization initiator (e) are respectively 0.3% or more with respect to the total weight of the photosensitive resin composition.

(6) The photosensitive resin composition for a laser engravable and cylindrical printing base material according to claim the above (5), wherein resin (a) is a liquid state at 20°C.
(8) The photosensitive resin composition for a laser engravable and cylindrical printing base material according to (5) and (6), further comprising at least one kind of microparticle selected from the group consisting of inorganic microparticles, organic microparticles and organic-inorganic composite microparticles.

(9) A laser engravable printing base material obtained by shaping the photosensitive resin composition for a laser engravable and cylindrical printing base material according to any of the above (5) to (7) into a sheet-shape or a cylindrical shape, then curing by irradiating with light in air.
(10) A multilayer printing base material, wherein the printing base material according to the above (8) comprises, on a lower portion, at least one layer of an elastomer layer having either a Shore A hardness of from 10 degrees or more to 70 degrees or less or an ASKER-C hardness of from 20 degrees or more to 85 degrees or less.
(11) The laser engravable multilayer printing base material according to the above (9), wherein the elastomer layer is formed by curing a laser engravable photosensitive resin composition which is a liquid state at 20°C.
(12) The process for producing a laser engravable and cylindrical printing base material according to the above (1), wherein the photosensitive resin composition has a viscosity between 10 Pa·s and 10 kPa·s at 20°C.
(14) The photosensitive resin composition for a laser engravable and cylindrical printing base material according to the above (5), wherein the resin (a) comprises the organic group and the bond directly bind to a carbon atom; the carbon atom binds to hydrogen atom(s) (α-hydrogen atom(s)) of no less than 10% with respect to the total of hydrogen atoms in the molecule.

### EFFECT OF THE INVENTION

According to the present invention, provided are a method for producing a photosensitive resin composition which can be cured by irradiating with light in air and a cured product of a photosensitive resin can be provided.

### BEST MODE FOR CARRYING OUT THE INVENTION

The present invention will now be described in more detail with the description focusing on preferable embodiments thereof.
The present invention provides a method for producing a photosensitive resin cured product photo-cured in air from a photosensitive resin composition formed in a thick-film of between 50 µm or more and 50 mm or less, and a photosensitive resin composition.
In the field of printing inks that contain a photosensitive resin composition which is photo-cured by a radical polymerization reaction, it is well known to carry out the photo-curing in air when the film thickness is a thin-film of less than 10 µm. However, when a thick-film curable resin composition is photo-cured in air, the photo-curing in the surface vicinity is inadequate. Therefore, the cured product having very strong stickiness on the surface occures. Therefore, when curing a thick-film using a conventional photosensitive resin composition, it is necessary to photo-cure by dividing it into multiple layers. However, if photo-curing can be performed with a thickness of 50 µm or more, a photosensitive resin cured product can be obtained in a short a period of time. In addition, if the thickness is no more than 50 mm, a photosensitive resin cured product can be obtained which is adequately cured as far as its interior. Obviously, by repeatedly coating and photo-curing over a number of times, it is also possible to form a photosensitive resin cured product with a thicker layer.

The printing base material of the present invention is not particularly limited as long as it allows photo-curing on a thick-film. The printing base material of the present invention can be used in various applications, such as a sheet or roll for a flexography original plate formed with an uneven pattern on its surface by laser engraving; a sheet or roll for a gravure printing; or a sheet or a rotary screen for screen printing formed with a holed pattern therethrough by irradiating with a laser beam; an original plate material for screen printing; a blanket roll used in an offset printing process; an ink-amount-controlled roll used by contacting with an anilox roll; a cushion roll for printing; a roll or the like mounted onto an inkjet printer, a laser printer, a copying machine or such device; or a three-dimensional molding or the like.

In the present invention, the term "air" is not limited to being a gaseous atmosphere whose oxygen concentration is about 21% by volume and whose nitrogen concentration is about 78% by volume as found close to the surface of the Earth. This term is defined as including gaseous atmospheres whose oxygen concentration is 10% by volume or more and 30% by volume or less. In the case of 10% by volume or more, the exposure operation can be carried out in a low oxygen concentration atmosphere by using a simple exhauster together with the apparatus for exposing the photosensitive resin composition. In the case of 30% by volume or less, combustion aiding properties can be suppressed to low level, and the physical properties of the photo-cured product can be ensured.
An aromatic ketone is used as the hydrogen abstraction-type photopolymerization initiator (d). It has been suggested that in this chemical reaction mechanism the aromatic ketone is efficiently turned into an excited triplet state by photoexcitation, and this excited triplet state abstracts hydrogen from the surrounding medium, whereby radicals are formed. It is also thought that the formed radicals participate in the photocrosslinking reaction. However, the hydrogen abstraction-type photopolymerization initiator (d) may be any compound as long as such compound forms radicals by being turned into an excited triplet state and abstracting hydrogen from a surrounding medium.
Examples of the aromatic ketone include benzophenones, Michler's ketones, xanthenes, thioxanthones and anthraquinones.
At least one compound selected from among this group is used. The term "benzophenones" refers to a benzophenone or derivative thereof; specific examples including 3,3',4,4'-benzophenone tetracarboxylic acid anhydride, 3,3',4,4'-tetramethoxybenzophenone and the like. The term "Michler's ketones" refers to a Michler's ketone or derivative thereof. The term "xanthenes" refers to a xanthene or derivative substituted with an alkyl group, phenyl group, or halogen group. The term "thioxanthones" refers to a thioxanthone or derivative substituted with an alkyl group, phenyl group, or halogen group, examples including ethylthioxanthone, methylthioxanthone, chlorothioxanthone and the like. The term "anthraquinones" refers to an anthraquinone or derivative substituted with an alkyl group, phenyl group, or halogen group. The added amount of the hydrogen abstraction-type photopolymerization initiator is preferably from 0.3% by weight or more to 10% by weight or less, and more preferably from 0.5% by weight or more to 5% by weight or less, with respect to the total amount of the photosensitive resin composition. If the added amount is in this range when the liquid photosensitive resin composition is photo-cured in air, the curability of the cured product layer surface can be sufficiently ensured. Additionally, problems such as cracking do not occur during long-term storage, thereby securing weatherability.

The term "disintegration-type photopolymerization initiator (e)" refers to a compound wherein a cleavage reaction occurs in the molecule after light has been absorbed, whereby reactive radicals are generated. Specific examples include benzoin alkyl ethers, 2,2-dialkoxy-2-phenylacetophenones, acetophenones, acyloxime esters, azo compounds and diketones. At least one kind of compound selected from these groups is used.

Examples of benzoin alkyl ethers include benzoin isoprpyl ether and benzoin butyl ether. Examples of 2,2-dialkoxy-2-phenylacetophenones include 2,2-dimethoxy-2-phenylacetophenone and 2,2-diethoxy-2-phenylacetophenone. Examples of acetophenones include acetophenone, trichloroacetophenone, 1-hydroxycyclohexylphenylacetophenone and 2,2-diethoxyacetophenone. Examples of acyloxime esters include 1-phenyl-1,2-propanedione-2-(o-benzoyl) oxime and the like.

Examples of azo compounds include azobisisobutyronitrile, diazonium compounds, tetrazene compounds and the like. Examples of diketones include benzyl, methylbenzoylformate and the like. The added amount of the disintegration-type photopolymerization initiator is preferably from 0.3% by weight or more to 10% by weight or less, and preferably 0.5% by weight or more to 5% by weight or less, of the total amount of the photosensitive resin composition. If the added amount is in this range, when photo-curing the liquid photosensitive resin composition in air, the curability of the cured product interior can be sufficiently secured.

A compound having in the same molecule a site which functions as a hydrogen abstraction-type photopolymerization initiator and a site which functions as a disintegration-type photopolymerization initiator can also be used as the photopolymerization initiator. α-aminoaceto phenones can be given as examples of such a compound. Such examples include compounds represented by the below general formula (1), such as 2-methyl-1-(4-methylthiophenyl)-2-morpholinopropane-1-one and 2-benzyl-2-dimethylamino-1-(4-morpholinophenyl)-butanone:

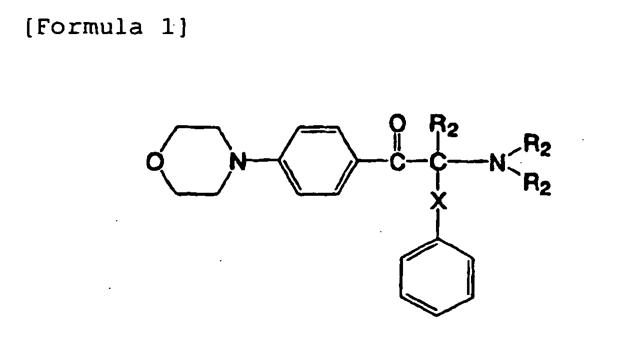

(wherein each R₂ independently represents a hydrogen atom or an alkyl group having from 1 to 10 carbons; and X represents an alkylene group having from 1 to 10 carbons).
The added amount of the photopolymerization initiator (c) having in the same molecule a site which functions as a hydrogen abstraction-type photopolymerization initiator and a site which functions as a disintegration-type photopolymerization initiator is preferably from 0.3% to 10% by weight, and more preferably from 0.5% to 3% by weight, with respect to the total amount of the photosensitive resin composition. If the added amount is in this range even when the liquid photosensitive resin composition is photo-cured in air, the mechanical properties of the cured product can be sufficiently secured.

While the photosensitive resin composition according to the present invention may be a solid or liquid state at 20°C, it is especially preferable for the photosensitive resin composition to be a liquid state at 20°C in terms of ease of shape forming. The term "liquid resin" as used here means a polymer which have the property of easily causing a flow and deformation and of being solidified into a deformed shape by cooling. This term is in contrast to an elastomer which has the property of causing a temporal deformation when applied with an external force in accordance with that external force, but which returns to its original shape in a short period of time when the external force is removed.

If the resin (a) is a liquid resin at 20°C, the photosensitive resin composition will also be a liquid state at 20°C. When shaping the to-be-obtained photosensitive resin composition into a sheet-like or cylindrical form the viscosity at 20°C is between 10 Pa·s and 10 kPa·s for the purpose of good thickness accuracy and dimensional accuracy. More preferable is from 50 Pa·s or more to 5 kPa·s or less. If the viscosity is 10 Pa·s or more, the mechanical strength of the photosensitive resin cured product is sufficient, and its shape can be easily maintained and easily worked even when molding into a cylinder shape. If the viscosity is 10 kPa·s or less, the deformation is easy even at room temperature and the processing is simple. It is easy to form the photosensitive resin composition into a sheet-like or cylindrical photosensitive resin cured product, and the process is also simple. In order to obtain a cylindrical photosensitive resin composition having particularly high thickness accuracy, the viscosity is preferably 100 Pa·s or more, more preferably is 200 Pa·s or more, and furthermore preferably 500 Pa·s or more so that phenomena such as the dripping of the photosensitive resin composition caused by the gravity can be avoided when forming the liquid photosensitive resin composition layer onto the cylindrical support.

It is preferable that the resin (a) according to the present invention includes, in its molecule, either at least one kind of organic group selected from the group consisting of an aryl group, a straight or branched chain alkyl group substituted with at least one aryl group, an alkoxycarbonyl group, a hydroxyl group and a formyl group or a bond of a carbonate bond or an ester bond; the organic group and the bond directly bind to a carbon atom; and the carbon atom binds to hydrogen atom(s) (α-hydrogen atom(s)) of no less than 2% to no more than 80% with respect to the total of hydrogen atoms in the molecule. While the reason is not clear, a photosensitive resin compound is provided which is capable of photo-curing even in air by using a compound having an above-described specific functional group of which organic group has a hydrogen atom bonded to a directly bonded carbon atom. Preferable examples of the aryl group include a phenyl group, tolyl group, xylyl group, biphenyl group, naphthyl group, anthryl group, pyrenyl group, phenanthryl group and the like. Further, preferable examples of the straight or branched chain alkyl group substituted with an aryl group include a methylstyryl group, a styryl group and the like. The content of α-site hydrogen can be analyzed by nuclear magnetic resonance spectroscopy (¹H-NMR) focused on the hydrogen atoms.

The resin (a) according to the present invention may be a solid or liquid state at 20°C. Especially, in case of forming into a complex shape such as a cylinder or the like, a liquid state is preferable.
The number average molecular weight of the resin (a) according to the present invention is from 1,000 or more to 200,000 or less, more preferably from 2,000 or more to 100,000 or less, and furthermore preferably from 5,000 or more to 50,000 or less. If the resin (a) number average molecular weight is 1,000 or more, the photosensitive resin cured product prepared by subsequently crosslinking can maintain its strength, so that if used as a printing base material or the like, repeated usage can be withstood. If 200,000 or less, viscosity of the photosensitive resin composition does not rise to an excessive level. Thus, complex processing methods such as heat-extruding or the like are not required when producing the sheet-like or cylindrical photosensitive resin cured product layer. The term "number average molecular weight" as used here is determined using gel permeation chromatography by calibrating with polystyrene having a known molecular weight to calculate the value.

The resin (a) may have a polymerizable unsaturated group in its molecule. From the perspective of mechanical strength, preferable compounds are polymers having polymerizable unsaturated groups per molecule of 0.7 or more, and more preferably 1 or more, on average. In the case of 0.7 or more per molecule, the photosensitive resin cured product obtained from the photosensitive resin composition according to the present invention has excellent mechanical strength and good durability, and is thus especially preferable as a printing base material capable of withstanding repeated usage. While there is no particular restriction on the upper limit of the number of polymerizable unsaturated groups per molecule, a preferable range does not exceed 20. In the case of no greater than 20, shrinkage during photo-curing can be suppressed to a low level, and the occurrences such as cracks in the surface vicinity can be suppressed.

The expression "in its molecule" as used here includes cases where a polymerizable unsaturated group is directly bonded to a terminal of a polymer main chain, the terminal of a polymer side chain, the polymer main chain or a side chain.
Specific example of resin (a) include compounds where a polymer such as those described below serves as the skeleton and further has the above-described specific functional group. As the polymer serving as the skeleton, one or more kinds selected from the group consisting of polymers having a hetero atom on a main chain of: polyolefins such as polyethylene, polypropylene or the like; polydienes such as polybutadiene, polyisoprene or the like; polyhaloolefins such as polyvinyl chloride, polyvinylidene chloride or the like; polystyrenes; polyacrylonitriles; polyvinyl alcohols; polyvinyl acetates; polyvinyl acetals; polyacrylic acids; poly(meth)acrylate esters; poly(meth)acrylamides; polyesters; polycarbonates; polyacetals; polyurethanes; polyamides; polyureas; polyimides or the like. If using a plurality of polymers, it does not matter whether these are used as a copolymer or as a blend.

Particularly, in situations where a flexible relief image such as flexography applications is necessary, a liquid resin preferably having a glass transition temperature of no higher than 20°C, and more preferably having a glass transition temperature of no higher than 0°C, can be partially added as the resin (a). Examples of such a liquid resin include hydrocarbons such as polyethylene, polybutadiene, hydrogenated polybutadiene, polyisoprene, hydrogenated polyisoprene and the like; polyester such as adipate, polycaprolactone and the like; polyethers such as polyethylene glycol, polypropylene glycol, polytetramethylene glycol and the like; aliphatic polycarbonates; silicones such as polydimethylsiloxane and the like; unsaturated polyurethanes; (meth)acrylic acids and/or the derivative polymers thereof, as well as mixtures or copolymers thereof. The added amount of such substance is preferably from 30% by weight or more to 100% by weight or less with respect to the total resin (a). Especially from the perspective of weatherability, unsaturated polyurethanes having a polycarbonate structure are preferable.

The method for introducing a polymerizable unsaturated group onto the compound constituting resin (a) may be a method which directly, for example, introduces a polymerizable unsaturated group onto the molecule terminal or onto the molecule chain. Also, there is another method that reacts a compound having a plurality of reactive groups such as a hydroxyl group, an amino group, an epoxy group, a carboxyl group, an acid anhydride group, a ketone group, a hydrazine residue, an isocyanate group, an isothiocyanate group, a cyclic carbonate group, an ester group and the like, with a binder having a plurality of functional groups which can bind to the above-described reactive groups (e.g. polyisocyanate for hydroxyl amino groups); adjusts the molecular weight of the resultant product; converts the terminals to binding groups; reacts the compound obtained in the reaction with a compound which has a polymerizable unsaturated group and functional groups which can be reacted with the terminal binding groups of the above compound obtained in the reaction; and introduces a polymerizable unsaturated group onto the terminal.

If the photosensitive resin cured product according to the present invention is used as a printing base material for laser engraving, it is preferable to use a compound which has high thermal decomposition properties as the resin (a). Examples of compounds which are known as having a high-temperature resistance include compounds having in their molecule α-methylstyrene, a methacrylate ester, an acrylate ester, a carbonate bond, a carbamate bond or the like. Data from thermal mass spectrometry which measures the decrease in mass during heating of a sample in an inert gas atmosphere may be used as an index for the thermal decomposition properties. Compounds showing that the temperature at the point where mass has decreased by half is in the range of 150°C or more to 450°C or less are preferable. A more preferable range is from 250°C or more to 400°C or less, and an even more preferable range is from 250°C or more to 380°C or less. In addition, compounds whose thermal decomposition occurs in a narrow temperature range are preferable. As an index for this, in the above-described thermal mass spectrometry, preferable is a difference of no greater than 100°C in between the temperature at which the initial mass decreases by 80% and the temperature at which the initial mass decreases by 20%. More preferable is a difference of no greater than 80°C, and furthermore preferable is a difference of no greater than 60°C.

The organic compound (b) according to the present invention is a compound which has an unsaturated bond that participates in a radical polymerization reaction. Considering the ease of dilution of the resin (a), the organic compound (b) preferably has a number average molecular weight of between 100 and 1,000. Examples of organic compound (b) include olefins such as ethylene, propylene, styrene and divinylbenzene; acetylenes; (meth)acrylic acid and derivatives thereof; haloolefins; unsaturated nitriles such as acrylonitrile; (meth)acrylamide and derivatives thereof; allyl compounds such as allyl alcohol and allyl isocyanate; unsaturated dicarboxylic acids such as maleic anhydride, maleic acid, fumaric acid and itconic acid and derivatives thereof; vinyl acetate; N-vinylpyrrolidone; N-vinylcarbazole; and cyanate esters. From the viewpoint of availability of the various products and cost etc., (meth)acrylic acid and (meth)acrylic acid derivatives are preferred.

Examples of derivatives such as (meth)acrylic acid and (meth)acrylic acid esters include compounds having an aliphatic group such as a cycloalkyl, a bicycloalkyl, a cycloalkylene or a bicycloalkylene; compounds having an aromatic group such as a benzyl, a phenyl, or a phenoxy; compounds having a group such as an alkyl, a halogenated alkyl, an alkoxyalkyl, a hydroxyalkyl, an aminoalkyl, a tetrahydrofurfuryl, an allyl or a glycidyl; and esters with a polyol such as an alkylene glycol, a polyoxyalkylene glycol, an (alkyl/allyloxy)polyalkylene glycol or trimethylol propane.
In the present invention, from the perspectives of suppressing swelling against an organic solvent and improving mechanical strength, the organic compound (b) which has such a polymerizable unsaturated group preferably comprises at least one kind or more of a compound containing a long-chain aliphatic group, an alicyclic group or an aromatic group. In this case such compound is preferably from 20% by weight or more to 100% by weight or less, and more preferably from 50% by weight or more to 100% by weight or less, with respect to the total weight of the organic resin (b).

In order to increase the impact resilience of the photosensitive resin cured product, for example, either a methacrylic monomer as described in JP-A-7-239548 or the conventional technical knowledge concerning photosensitive resin compositions for printing may be employed.
The photosensitive resin composition according to the present invention can be charged with inorganic microparticles, organic microparticles, organic-inorganic composite microparticles and the like. The photosensitive resin cured product obtained by adding such microparticles and photo-curing can improve its mechanical strength and the wettability of the surface of the photosensitive resin cured product layer, or can regulate viscosity of the photosensitive resin composition and viscoelasticity of the photosensitive resin cured product and the like. The material for the inorganic microparticles or organic microparticles is not especially limited, and the well-known materials may be used. Examples of the organic-inorganic composite microparticles include microparticles formed from an organic layer or an organic microparticle on the surface of an inorganic microparticle, or alternatively, an inorganic layer or an inorganic microparticle on the surface of an organic microparticle.

High-rigidity inorganic microparticles of silicon nitride, boron nitride, silicon carbide or the like or organic microparticles of polyimide or the like can be used to improve the mechanical properties of the photosensitive resin cured product. Further, when used as a cushion material or a blanket material, organic hollow microparticles, porous microparticles or organic microparticles formed from an extremely soft material can be added in order to improve shock absorption properties. Still further, inorganic microparticles or organic microparticles formed from a material having good swelling properties with respect to the solvent to be used can be also added in order to improve the solvent resistance of the obtained photosensitive resin cured product.

Further, for the purpose of forming a pattern by laser engraving which extends through the photosensitive resin cured product layer surface or the photosensitive resin cured product, inorganic porous microparticles or the like having the excellent adsorption removal properties of the viscous liquid debris generated during laser engraving may be added. Examples include, but are not especially limited to, porous silica, mesoporous silica, a silica-zirconia porous gel, porous alumina, porous glass and the like.

The microparticles used in the present invention preferably have a number average particle size of between 0.01 to 100 µm. If microparticles are used which have a number average particle size in this range when mixing the resin (a) and the organic compound (b), the disadvantages such as rising viscosity, entrapment of air bubbles, formation of large quantities of dust and the like are not caused. There is also no formation of uneven portions on the surface of the photosensitive resin cured product layer. A more preferable range for the number average particle size from 0.1 to 20 µm, and an furthermore preferable range is from 1 to 10 µm. The number average particle size of the microparticles in the present invention is the value measured using a laser scattering particle size distribution analyzer.
There is no particular limitation with respect to the particle shape of the microparticles. Spheres, flat shapes, needle shapes, amorphous shapes or particles having a projection on their surface can be used. Especially from the viewpoint of abrasion resistance, sphere-shaped particles are preferable.
Further, particles having an hydrophilic or hydrophobic property improved by carrying out a surface modification treatment by coating the surface of the microparticles with a silane coupling agent, a titanium coupling agent or the other organic compound can be also used.

In the present invention, these microparticles can be used individually or in combination of two or more.
The ratio of resin (a), organic compound (b) and the microparticles in the photosensitive resin composition of the present invention is, in general, preferably 5 to 200 parts by weight of organic compound (b) relative to 100 parts by weight of resin (a), and more preferably 20 to 100 parts by weight relative to 100 parts by weight of resin (a). Also, the ratio of the microparticles is preferably 1 to 100 parts by weight relative to 100 parts by weight of resin (a), more preferably 2 to 50 parts by weight relative to 100 parts by weight of resin (a), and still more preferably 2 to 20 parts by weight of microparticles relative to 100 parts by weight of resin (a).
If the ratio of organic compound (b) is in the above range, it is easy to obtain a good balance between the hardness and the tensile strength of the photosensitive resin cured product, the shrinkage during the photo-curing is kept to a low amount, and the thickness accuracy can be adequately secured.
In addition, according to the use and intended purpose, other additives such as a polymerization inhibitor, an ultraviolet absorber, a dye, a pigment, a lubricant, a surfactant, a plasticizer and a fragrance may be added to the photosensitive resin composition.

The photosensitive resin cured product according to the present invention is formed by the photo-curing of a photosensitive resin composition. Accordingly, a three-dimensional crosslinked structure is formed by the reaction of the polymerizable unsaturated groups in the organic compound (b) or by the reaction of the polymerizable unsaturated groups in the resin (a) and the organic compound (b), and the resultant structure becomes insoluble in the conventionally used solvents such as esters, ketones, aromatic compounds, ethers, alcohols and halogenated solvents. This reaction occurs between organic compounds (b), between resins (a), or between a resin (a) and an organic compound (b), thereby consuming the polymerizable unsaturated groups. When the photo-curing is carried out using a photopolymerization initiator, the photopolymerization initiator is decomposed by light. Thus, the unreacted photopolymerization initiator and the decomposition products thereof can be identified by extracting the photosensitive resin cured product with a solvent and analyzing the extracted product by GC-MS (a method in which products separated by gas chromatography are analyzed by mass spectroscopy), LC-MS (a method in which products separated by liquid chromatography are analyzed by mass spectroscopy), GPC-MS (a method in which products separated by gel permeation chromatography are analyzed by mass spectroscopy), or LC-NMR (a method in which products separated by liquid chromatography are analyzed by nuclear magnetic resonance spectroscopy). Further, from analysis of the above-mentioned solvent extract by GPC-MS, LC-MS or GPC-NMR, it is also possible to identify unreacted resin (a), unreacted organic compound (b) and the formed products having a comparatively low molecular weight obtained by the reaction of the polymerizable unsaturated groups. With respect to a high molecular weight component which has a three-dimensionally crosslinked structure and is insoluble in the solvent, thermal gravimetric GC-MS can be used to confirm the presence of sites formed by the reaction of the polymerizable unsaturated groups as the components constituting the high molecular weight materials. For example, the presence of a site whose polymerizable unsaturated group such as a methacrylate group, an acrylate group, a vinyl group and the like reacted can be estimated from the mass spectrum pattern. Thermal gravimetric GC-MS is a method in which a sample is decomposed by heat, the generated gas is separated into its components by gas chromatography, and followed by mass spectroscopic analysis of the separated components. When the unreacted photopolymerization initiator or the decomposition products derived from the photopolymerization initiator is detected in the photosensitive resin cured product together with the unreacted polymerizable unsaturated groups or sites formed by a reaction of the polymerizable unsaturated groups, it can be concluded that the analyzed product is a substance obtained by photo-curing a photosensitive resin composition.

The molecular structure of the resin (a) or the photopolymerization initiator in the photosensitive resin composition according to the present invention can be identified by separating and purifying by liquid chromatography such as GPC or LC, and then using nuclear magnetic resonance spectrometry (NMR). In the case of using NMR (¹H-NMR) in which hydrogen is taken as the observed nucleus, the kind of functional groups present in the molecule can be identified by analyzing the chemical shift which is peculiar to the functional groups. The quantity of hydrogen atoms (α-hydrogen atoms) which are directly bonded to a carbon atom having the specific functional group can also be quantitatively evaluated from the integrated value. For example, if the resin (a) used in the present invention is analyzed by ¹H-NMR, whether an above-described specific functional group is present can be detected from its chemical shift. In addition, the ratio of hydrogen atoms (α-hydrogen atoms) directly bonded to a carbon atom having a specific functional group can be determined from the integrated value. In other words, this ratio can be obtained as the ratio between the integrated value of the peak corresponding to the hydrogen atom (α-site hydrogen) being focused on and the sum of the integrated values of the peaks corresponding to all of the hydrogen atoms. When determining the integrated values, it is preferable to use a sufficient amount of sample for the measurement, and to sufficiently decrease the noise level by many times of accumulation and the like. For the resin (a) of the present invention, a preferable range for the ratio of α-hydrogen atoms derived from a specific functional group with respect to all the hydrogens in the resin (a) is 2% or more. More preferable is 5% or more, and furthermore preferable is 10% or more. If the ratio is 2% or more, the photosensitive resin composition can be sufficiently cured even for the photo-curing in air. There is no particular upper limit for this ratio, but a preferable upper limit is 80%. This is because it is impossible for all of the hydrogen atoms to be an α-site hydrogen.

With respect to the method for forming the photosensitive resin composition according to the present invention into a sheet or a cylinder shape, any conventional shaping method can be employed. Examples include a casting method; a method in which a resin is extruded from a nozzle or a die by using a machine such as a pump or an extruder, followed by adjustment of the thickness of the extruded resin using a blade; a method which adjusts thickness by calendaring with a roll; and an atomization method which uses a spray or the like. During the shaping, the resin can be heated at a temperature which does not the photosensitive resin composition to thermally decompose. Further, if desired, the shaped resin may be subjected to a pressure rolling treatment or an abrasion treatment.

Typically, the photosensitive resin composition is shaped on a sheet-like support called as a "back film" which is made of PET, nickel or the like. Alternatively, the resin composition can be shaped directly on a cylinder of a printing machine. A cylindrical substrate can also be used which is made from a sleeve of a polyester resin which is reinforced with fiber such as glass fiber, aramide fiber, carbon fiber or the like, a sleeve of plastic such as an epoxy resin, or a polyester tube of polyethylene terephthalate or the like. The function of the sheet-like or cylindrical support is to impart dimensional stability to the photosensitive resin cured product. Therefore, it is preferred to use a support having a high dimensional stability. In the case of the evaluation by linear thermal expansion coefficient, the upper limit for preferred materials is no more than 100 ppm/°C, and more preferably not more than 70 ppm/°C. Specific examples of such materials include a polyester resin, a polyimide resin, a polyamide resin, a polyamideimide resin, a polyetherimide resin, a poly-bismaleimide resin, a polysulfone resin, a polycarbonate resin, a polyphenylene ether resin, a polyphenylene thioether resin, a polyethersulfone resin, a liquid crystal resin composed of a wholly aromatic polyester resin, a wholly aromatic polyamide resin, and an epoxy resin. These resins may also be used by laminating together. In addition, a porous sheet (e.g. a cloth obtained by weaving a fiber) or object forming pores in a nonwoven fabric or a film can be also used as a sheet-like support. When a porous sheet is used as the sheet-like support, the pores in the porous sheet may be impregnated with a liquid photosensitive resin composition, the photo-curing of the resin composition is carried out, the photosensitive resin cured product is unified with the sheet-like support, whereby it is possible to achieve a strong adhesion therebetween. Examples of fibers which can be used to form a cloth or nonwoven fabric include inorganic fibers such as a glass fiber, an alumina fiber, a carbon fiber, an alumina-silica fiber, a boron fiber, a high silicon fiber, a potassium titanate fiber and a sapphire fiber; natural fibers such as cotton and linen; semi-synthetic fibers such as a rayon and an acetate fiber; and synthetic fibers such as those made from nylon, polyester, acryl, vinylon, polyvinyl chloride, polyolefin, polyurethane, polyimide and aramid. Cellulose produced by bacteria is a highly crystalline nanofiber, which can be used to produce a thin nonwoven fabric having a high dimensional stability.

Examples of methods for decreasing the linear thermal expansion coefficient of the support include adding a filler, and impregnating or coating a meshed cloth or glass cloth made from a wholly aromatic polyamide or the like with a resin. The fillers may be conventional fillers such as organic microparticles, inorganic microparticles of metal oxides or metals, and organic-inorganic composite microparticles. Further, the fillers may be porous microparticles, hollow microparticles, microcapsule particles or particles of compounds having a lamellar structure in which a low molecular weight compound is intercalated. Especially, useful are microparticles of metal oxides such as alumina, silica, titanium oxide and zeolite; latex microparticles comprised of a polystyrene-polybutadiene copolymer; and organic microparticles of natural substances such as a highly crystalline cellulose.

The surface of the support used in the present invention may be physically or chemically treated so as to improve its adhesion to the photosensitive resin composition layer or an adhesive agent layer. Examples of a physical treatment include sand blasting, wet blasting (in which a liquid containing the microparticles is sprayed), a corona discharge treatment, a plasma treatment, UV light irradiation and vacuum UV light irradiation. Examples of a chemical treatment method include treating with a strong acid and strong alkali, an oxidation agent or a coupling agent.

The shaped photosensitive resin composition layer is crosslinked by irradiating with light, thereby forming a photosensitive resin cured product. Crosslinking may be also carried out by irradiating with light while shaping. Examples of the light source used for curing include a high pressure mercury lamp, an ultra-high pressure mercury lamp, an ultraviolet fluorescent lamp, a germicidal lamp, a carbon arc lamp, a xenon lamp, a metal halide lamp and the like. The light irradiated onto the photosensitive resin composition layer preferably has a wavelength of between 200 nm and 300 nm. Especially, since many hydrogen abstraction-type photopolymerization initiators strongly absorb the light in this wavelength if light having a wavelength of between 200 nm and 300 nm is used, the curability of the photosensitive resin cured product surface can be sufficiently ensured. While the light source may be of a single kind, using two or more kinds which have different wavelengths often improve the resin curability. Therefore, two kinds or more of light source may be used.
The thickness of the photosensitive resin cured product layer is from 50 µm to 50 mm according to the intended use. When used as a printing base material, the thickness is preferably in a range of from 0.1 to 10 mm. In some cases, multiple layers of materials having different compositions can be used.

In the present invention, a cushion layer of an elastomer can be formed at a lower portion of the photosensitive resin cured product layer. Since the thickness of the photosensitive resin cured product layer formed in the present invention is from 50 µm to 50 mm, the other lower layers may be a material which has a different composition. The cushion layer is preferably an elastomer layer having a Shore A hardness of from 10 degrees or more to 70 degrees or less or an elastomer layer having an ASKER-C hardness of from 20 degrees or more to 85 degrees or less as measured with a ASKER-C hardness tester. If the Shore A hardness of the elastomer layer is 10 degrees or more or the ASKER-C hardness is 20 degrees or more, the printing quality can be secured because the deformation is carried out in a suitable manner. Further, if the Shore A hardness of the elastomer layer is 70 degrees or less or the ASKER-C hardness is 85 degrees or less, its function as a cushion layer can be achieved. A more preferable Shore A hardness range is from 20 to 60 degrees. Also, more preferable ASKER-C hardness is from 45 to 75 degrees. It is preferable to select either Shore A hardness or ASKER-C hardness according to the material to be used in the cushion layer. The difference between the two kinds of hardness derives from differences in the pushed needle shape of the hardness tester used in the measurement. In the case of a uniform resin composition, it is preferable to use Shore A hardness. In the case of non-uniform resin compositions, for example a foamed base material made from polyurethane foam, polyethylene foam or the like, it is preferable to use ASKER-C hardness. ASKER-C hardness can be measured in accordance with the provisions in JIS K7312.

The cushion layer is not particularly limited as long as it has rubber elasticity made from a thermoplastic elastomer, a photo-curable elastomer, a heat-curable elastomer or the like. The cushion layer may be also made from a porous elastomer having nanometer-size micropores. From the viewpoint of workability of the sheet-like or cylindrical printing base material, it is simple and preferred to use a liquid photosensitive resin composition that cures by light, which turns into an elastomer after being cured.
Specific examples of the thermoplastic elastomer used in the cushion layer include styrene thermoplastic elastomers, such as SBS (polystyrene-polybutadiene-polystyrene), SIS (polystyrene-polyisoprene-polystyrene) and SEBS (polystyrene-polyethylene/polybutyrene-polystyrene); olefin thermoplastic elastomers; urethane thermoplastic elastomers; ester thermoplastic elastomers; amide thermoplastic elastomers; silicon thermoplastic elastomers; and fluorine thermoplastic elastomers.

Examples of the photocurable elastomer include a mixture obtained by mixing the above-mentioned thermoplastic elastomer with a photopolymerizable monomer, a plasticizer, a photopolymerization initiator and the like; and a liquid photosensitive resin composition obtained by mixing a photopolymerizable monomer, a photopolymerization initiator and the like into a liquid resin. The present invention is unlike the design concept of a photosensitive resin composition in which the ability to form a fine pattern is an important factor. Indeed, it is not required to form a fine pattern using light. Thus, since the curing can be carried out by exposing the entire surface so long as the desired mechanical strength is secured, the freedom of material selection is very high.
Further, the cushion layer may be also formed from vulcanized rubbers, organic peroxides, primary condensates of a phenolic resin, quinone dioxime, metal oxides and non-vulcanized rubbers which is used a compound such as thiourea as a crosslinking agent.

Further, it is also possible to use an elastomer obtained by three dimensionally crosslinking a telechelic liquid rubber with a curing agent that reacts therewith as the cushion layer.
The cushion layer may be also made from polyurethane foam, polyethylene foam or the like, wherein independent or continuous air bubbles are formed in the layer. In addition, cushion material or cushion tape that are commercially available can be also used. Also, an adhesive or a pressure-sensitive adhesive may be coated on one or both sides of the cushion layer.
If the present invention is used as a printing base material formed in multiple layers, the position of the support may either be below the cushion layer (i.e., at the bottom of the printing base material) or in between the photosensitive resin cured product layer and the cushion layer (i.e., in a middle portion of the printing base material).

In addition, a modifier layer may be provided on the surface of the photosensitive resin cured product according to the present invention so as to decrease the surface tack of the printing base material and improve ink wettability. Examples of modifier layers include a coating treated with a compound which reacts with hydroxyl groups present on the surface of the silane coupling agent, titanium coupling agent or the like; and a polymer film containing porous inorganic particles.
Silane coupling agents which are commonly used are compounds having in the molecules thereof a functional group which is highly reactive with the surface hydroxyl groups of the printing base material. Examples of such functional groups include a trimethoxysilyl group, a triethoxysilyl group, a trichlorosilyl group, a diethoxysilyl group, a dimethoxysilyl group, a dimonochlorosilyl group, a monoethoxysilyl group, a monomethoxysilyl group and a monochlorosilyl group. At least one of these functional groups is present in the silane coupling agent, whereby the silane coupling agent is immobilized on the surface of the printing base material by the reaction between the functional group and the surface hydroxyl groups of the printing base material. Further, the compound which constitutes the silane coupling agent in the present invention may further contain in the molecules thereof at least one reactive functional group selected from the group consisting of an acryloyl group, a methacryloyl group, an amino group containing an active hydrogen, an epoxy group, a vinyl group, a perfluoroalkyl group and a mercapto group; or may contain a long chain alkyl group.

Examples of titanium coupling agents include compounds such as isopropyl triisostearoyl titanate, isopropyl tris(dioctylpyrophosphate) titanate, isopropyl tri(N-aminoethyl-aminoethyl) titanate, tetraoctyl bis(di-tridecyl phosphite) titanate, tetra(2,2-diallyloxymethyl-1-butyl) bis(di-tridecyl) phosphite titanate, bis(octyl pyrophosphate) oxyacetate titanate, bis(dioctyl pyrophosphate) ethylene titanate, isopropyl trioctanoyl titanate, isopropyl dimethacryl isostearoyl titanate, isopropyl tridodecylbenzenesulfonyl titanate; isopropyl isostearoyl diacryl titanate, isopropyl tri(dioctyl sulfate) titanate, isopropyl tricumylphenyl titanate, and tetraisopropyl bis(dioctyl phosphite) titanate.

Especially, when the coupling agent immobilized on the surface has a polymerizable reactive group, the immobilized coupling agent may be crosslinked by irradiation with light, heat or electron beam to thereby further improve the strength of a coating.
In the present invention, the above-mentioned coupling agent may be regulated by diluting as necessary with a mixture of water and an alcohol or a mixture of an aqueous acetic acid and an alcohol. The concentration of the coupling agent in the treatment solution is preferably from 0.05 to 10.0% by weight.

The treatment method of a coupling agent will be explained hereinafter.
It is preferable to coat a solution containing the above-mentioned coupling agent onto the surface of the printing base material. The coating method for the coupling agent treatment solution is not particularly limited. For example, the coupling agent treatment solution may be coated by immersing, spraying, roll coating or a coating with a brush. There coating temperature and the coating time are not particularly limited, but it is preferred that the coating temperature and the coating time are 5 to 60°C and 0.1 to 60 seconds, respectively. It is also preferred that the drying of the coupling agent treatment solution layer formed on the surface of the printing base material is performed by heating, and the preferred heating temperature is 50 to 150°C.
Before treating the surface of the printing base material with a coupling agent, the surface of the printing base material may be irradiated with vacuum ultraviolet light having a wavelength of not more than 200 nm by a xenon excimer lamp or exposed to a high energy atmosphere (such as plasma), to thereby generate hydroxyl groups on the surface of the printing base material, whereby the coupling agent is immobilized in a high density thereon.

In the case of using the photosensitive resin cured product according to the present invention as a printing base material formed with a pattern by laser engraving, in the laser engraving process, a desired image is converted into digital data, and a relief image is formed on the printing base material by controlling a laser apparatus with a computer. The laser used for the laser engraving may be any type of laser so long as the laser comprises light having a wavelength which can be absorbed by the printing base material. However, for the purpose of performing the laser engraving quickly, it is preferred that the output of the laser high. One of the preferred examples is an infrared laser or near-infrared laser such as a carbon dioxide laser, a YAG laser and a semiconductor laser. Further, the second harmonic of a YAG laser having an oscillation wavelength in a visible light range, a copper vapor laser, and ultraviolet lasers having an oscillation wavelength in a ultraviolet light range such as an excimer laser and a YAG laser tuned to the third or fourth harmonics may be used for an abrasion treatment (which breaks the bonds in the organic molecule), and thus are suitable for a precise processing. The laser may be either a continuous irradiation or a pulse irradiation. In general, resins absorb a carbon dioxide laser having a wavelength around 10 µm, and so there is no need to add a component for facilitating the absorption of the laser beam. However, a YAG laser has an oscillation wavelength of around 1.06 µm is used, and not many compounds absorb light having such a wavelength. Thus, in this case it is preferable to add a component, e.g. a dye or a pigment, for facilitating absorption. Examples of dyes include a poly(substituted)-phthalocyanine compound and a metal-containing phthalocyanine compound, a cyanine compound, a squalilium dye, a chalcogenopyryloallylidene dye, a chloronium dye, a metal thiolate dye, a bis(chalcogenopyrylo)polymethine dye, an oxyindolidene dye, a bis(aminoaryl)polymethine dye, a melocyanine dye and a quinoid dye. Examples of pigments include dark colored inorganic pigments such as carbon black, graphite, copper chromite, chromium oxide, cobalt chromium aluminate, copper oxide and iron oxide; powders of metals such as iron, aluminum, copper and zinc; and doped metal powders which are obtained by doping any of the above-mentioned metal powders with Si, Mg, P, Co, Ni, Y or the like. These dyes and pigments can be used individually or in combination thereof, and can be also combined in any form such as a multilayer structure. However, when the photosensitive resin composition is cured with light, the added amount of organic or inorganic compound, which has a large light-absorbance at the wavelength of the light being used in curing, is preferably in a range which does not hinder photo-curability. The added ratio with respect to the total weight of the photosensitive resin composition is preferably from no less than 0.01% by weight to no more than 5% by weight, and more preferably from no less than 0.01% by weight to no more than 2% by weight.

The laser engraving can be performed in an oxygen-containing gas atmosphere, generally in the presence of air or under the flow of air. However, it can be also performed in an atmosphere of carbon dioxide gas or nitrogen gas. Powdery or liquid substances which are present in a small amount on the surface of the relief printing plate obtained by laser engraving may be removed by an appropriate method, such as a method of washing with a mixture of water with a solvent or surfactant contained therein, a method of high pressure spraying of an aqueous detergent or a method of spraying of a high pressure steam.
In the present invention, when forming the pattern by irradiating a laser beam onto the printing base material, the laser engraving can be assisted by heating the printing base material surface. Examples of the method for heating the printing base material include using a heater to heat the sheet-like or cylindrical block of the laser engraving apparatus; and using an infrared heater to directly heat the printing base material surface. The laser engraving properties can be improved as a result of this heating step. The heating temperature is preferably in a range of from 50°C to 200°C, more preferably 80°C to 200°C, and still more preferably 100°C to 200°C.

In the present invention, after the engraving for forming a pattern by irradiation of a laser beam, a step can be carried out to remove powdery or viscous liquid debris which remains on the surface of the printing plate, which is then followed by a post-exposure operation, in which light having a wavelength of from 200 nm to 450 nm is irradiated onto the surface of the patterned printing plate. This method is effective in removing surface tack. The post-exposure operation can be performed in air, inert gas atmosphere or water. This operation is particularly effective when a hydrogen abstraction-type photopolymerization initiator is contained in the photosensitive resin composition being used. Further, the printing plate surface prior to the post-exposure operation may be exposed by treating with a treating solution which includes a hydrogen abstraction-type photopolymerization initiator. The post-exposure operation can be also carried out by dipping the printing plate in a treating solution which includes a hydrogen abstraction-type photopolymerization initiator.

### EXAMPLES

The present invention will be explained hereinafter based on the following Examples and Comparative Examples, however the present invention is not limited thereto.

### (1) Laser Engraving

Laser engraving was performed using a carbon dioxide laser engraver (tradename: "ZED-mini-1000"; manufactured by ZED Instruments, Great Britain; mounted with a 250 W output carbon dioxide gas laser manufactured by Coherent Inc., USA). The engraving was carried out by producing a pattern which included halftone dots (area ratio of 10% at 3.2 lines/mm), a line drawing formed from 500 µm-wide ridges, and 500 µm-wide reverse lines. If the engraving is set at a large depth, the top portion surface area of the precise halftone dot portion pattern cannot be properly obtained, and the shape also breaks down and becomes ill-defined. For this reason, the engraving depth was set at 0.55 mm.

### (2) Viscosity

The viscosity of the photosensitive resin composition was measured using a B type viscometer (tradename: B8H model; manufactured by Tokyo Keiki Co., Ltd., Japan) at 20°C.

### (3) Measurement of Number Average Molecular Weight

The number average molecular weight of resin (a) and organic compounds (b) were calculated using known-molecular-weight polystyrene by gel permeation chromatography (GPC). Measurement was carried out using a high performance GPC apparatus (tradename: HLC-8020; manufactured by Tosoh Corporation, Japan) and a polystyrene-packed column (tradename: "TSKgel GMHXL"; manufactured by Tosoh Corporation, Japan) wherein tetrahydrofuran (THF) was used as a carrier. The column temperature was set at 40°C. A THF solution containing 1% by weight of the resin was prepared as a sample, and 10 µl of this prepared sample was charged into the GPC apparatus. An ultraviolet absorption detector was used as a detector for resin (a), wherein light having a wavelength of 254 nm was used as the monitoring light. As for the organic silicon compound (c) detection was carried out using a parallax refractometer. Since the polydisperity (Mw/Mn) as measured by GPC of the resin (a) and organic silicon compound (c) used in the Examples and Comparative examples of the present invention was greater than 1.1, the number average molecular weight as measured by GPC was employed instead. Further, since the polydisperity as measured by GPC of the organic compound (b) was smaller than 1.1, its molecular weight was calculated from the molecular structure identified from NMR.

### (4) Measurement of the Number of Polymerizable Unsaturated Groups

The average number of polymerizable unsaturated groups present in a synthesized resin (a) molecule was determined by removing the unreacted low molecular weight components using liquid chromatography, and then using nuclear magnetic resonance spectroscopy (NMR) to analyze the molecular structure.

### (5) Measurement of Nuclear Magnetic Resonance Spectrometry

¹H-NMR measurement was conducted using a "JNM-LA400" (tradename) manufactured by JEOL Ltd. The observation frequency was 400 MHz, the accumulation number was 256, and tetramethylsilane was used as the standard substance.

### (6) Measurement of Shore A hardness

Measurement of Shore A hardness was conducted using an automatic hardness tester manufactured by Zwick GmbH (Germany). The value measured 15 seconds after measurement was used as the Shore A hardness. The used cushion was employed as a sample, and Shore A hardness was measured without changing the thickness.

### (7) ASKER-C Hardness

The ASKER-C hardness was measured using a rubber/plastic hardness tester (tradename: "ASKER-C Model; manufactured by Kobunshi Keiki Co., Ltd.) The value measured 15 seconds after measurement was used as the ASKER-C hardness. The used cushion was employed as a sample, and the ASKER-C hardness was measured without changing the thickness

### (8) Tack Measurement

Measurement of tack on the surface of the photosensitive resin cured product was conducted using a tack tester (manufactured by Toyo Seiki Seisaku-Sho Ltd.). Specifically, an aluminum ring having a radius of 50 mm and a width of 13 mm was brought into contact at the 13 mm-width portion with to a smooth portion of a test piece at 20°C. A load of 0.5 kg was applied to the aluminum ring for 4 seconds. Subsequently, the aluminum ring was pulled at a fixed rate of 30 mm per minute and the resisting force at the time of the detachment of the aluminum ring from the test piece was measured by means of a push-pull gauge. The larger the resisting force, the larger the stickiness.

### (Production Example 1)

A 1-liter separable flask equipped with a thermometer, a stirring device and a reflux system was charged with 447.24 g of a polycarbonate diol manufactured by Asahi Kasei Corporation (tradename: "PCDL L4672"; number average molecular weight of 1,990; OH number 56.4) and 30.83 g of tolylene diisocyanate. The resultant mixture was reacted for about 3 hours under heating at 80°C, and then charged with 14.83 g of 2-methacryloyloxy isocyanate. This mixture was further made to react for about 3 hours, to thereby produce a resin (i) having a methacrylic group on a terminal (an average of about 2 polymerizable unsaturated groups per molecule) and whose number average molecular weight was about 10,000. This resin was like a starch syrup at 20°C, and flowed even if an external force was applied. In addition, it did not return to its original form when the external force was removed. In the obtained resin (i), the α-hydrogen atoms were the hydrogen atom bound to the carbon to which the carbonate bond oxygen atom was directly bound, and the hydrogen atom at the site where the molecule terminal methacrylate ester bond was formed. The results of nuclear magnetic resonance spectrometry (¹H-NMR) analysis focusing on the hydrogen atoms were that the α-hydrogen atoms were the hydrogen atom bound to the carbon to which the carbonate bond oxygen atom was directly bound (value of chemical shift under ¹H-NMR: 4.1 to 4.2 ppm), the hydrogen atom at the site where the molecule terminal methacrylate ester bond was formed (value of chemical shift under ¹H-NMR: 4.1 to 4.2 ppm), and the hydrogen atom bound to the carbon to which the unreacted terminal hydroxyl group was bound. From the integrated value of NMR measurement, the content of the α-hydrogen atoms was 44.8%.

### (Production Example 2)

A 1-liter separable flask equipped with a thermometer, a stirring device and a reflux system was charged with 447.24 g of a polycarbonate diol manufactured by Asahi Kasei Corporation (tradename: "PCDL L4672"; number average molecular weight of 1,990; OH number 56.4) and 30.83 g of tolylene diisocyanate. The resultant mixture was reacted for about 3 hours under heating at 80°C, and then charged with 7.42 g of 2-methacryloyloxy isocyanate. This mixture was further made to react for about 3 hours, to thereby produce a resin (ii) having a methacrylic group on a terminal (an average of about 1 polymerizable unsaturated group in it's molecule per molecule) and whose number average molecular weight was about 10,000. This resin was like a starch syrup at 20°C, and flowed even if an external force was applied. In addition, it did not return to its original form when the external force was removed. In the obtained resin (ii), the α-hydrogen atoms were the hydrogen atom bound to the carbon to which the carbonate bond oxygen atom was directly (value of chemical shift under ¹H-NMR: 4.1 to 4.2 ppm), the hydrogen atom at the site where the molecule terminal methacrylate ester bond was formed (value of chemical shift under ¹H-NMR: 4.1 to 4.2 ppm), and the hydrogen atom bound to the carbon to which the unreacted terminal hydroxyl group was bound (value of chemical shift under ¹H-NMR: 3.6 to 3.7 ppm). From the integrated value of NMR measurement, the content of the α-hydrogen atoms was 45.2%.

### (Production Example 3)

A 1-liter separable flask equipped with a thermometer, a stirring device and a reflux system was charged with 450 g of a polyester diol manufactured by Kuraray Co., Ltd. (tradename: "Kuraray Polyol P3010"; number average molecular weight of 3,161; OH number 35.5) and 21.52 g of tolylene diisocyanate. The resultant mixture was reacted for about 3 hours under heating at 80°C, and then charged with 6.44 g of 2-methacryloyloxy isocyanate. This mixture was further made to react for about 3 hours, to thereby produce a resin (iii) having a methacryl group on a terminal (an average of about 2 polymerizable unsaturated groups per molecule) and whose number average molecular weight was about 25,000. This resin was like a starch syrup at 20°C, and flowed even if an external force was applied. In addition, it did not return to its original form when the external force was removed. In the obtained resin (iii), the α-hydrogen atoms were the hydrogen atom at the site where the ester bond in the molecule chain was formed (value of chemical shift under ¹H-NMR: 4.1 to 4.2 ppm), the hydrogen atom at the site where the molecule terminal methacrylate ester bond was formed (value of chemical shift under ¹H-NMR: 4.1 to 4.2 ppm), and the hydrogen atom bound to the carbon to which the branched methyl group was bound (value of chemical shift under ¹H-NMR: 1.8 ppm). From the integrated value of NMR measurement, the content of the α-hydrogen atoms was 25.2%.
One of the hydrogens (α-hydrogen atoms) bound to the carbon to which the methyl group was directly bound and the hydrogens bound to carbons which exists on both sides of the carbon exhibited almost the same chemical shift value. For this reason, the integrated value of such α-site hydrogen was obtained by dividing the integrated value of the methyl group hydrogens by three.

### (Production Example 4)

A 1-liter separable flask equipped with a thermometer, a stirring device and a reflux system was charged with 508 g of a polyoxypropylene/polyoxyethylene block copolymer having a number average molecular weight of about 2,500, 339 g of poly(3-methyl-1.5-pentanediol adipate) having a number average molecular weight of about 3,000, and 60.5 g of tolylene diisocyanate. The resultant mixture was reacted for about 3 hours under heating at 60°C, and then 40.6 g of 2-hydroxypropyl methacrylate and 50.1 g of polypropylene glycol monomethacrylate having a number average molecular weight of about 380 were added. This mixture was further made to react for about 2 hours, to thereby produce a resin (iv) having a methacryl group on a terminal (an average of about 2 polymerizable unsaturated groups per molecule) and whose number average molecular weight was about 22,500. This resin was like a starch syrup at 20°C, and flowed even if an external force was applied. In addition, it did not return to its original form when the external force was removed. The α-hydrogen atoms were the hydrogen atom at the site where the ester bond in the molecule chain was formed (value of chemical shift under ¹H-NMR: 4.1 to 4.2 ppm), the hydrogen atom at the site where the molecule terminal methacrylate ester bond was formed (value of chemical shift under ¹H-NMR: 4.1 to 4.2 ppm), and the hydrogen atom bound to the carbon to which the branched methyl group was bound (value of chemical shift under ¹H-NMR: 1.8 ppm). From the integrated value of NMR measurement, the content of the α-hydrogen atoms was 15.5%.
One of the hydrogens (α-hydrogen atoms) bound to the carbon to which the methyl group was directly bound and the hydrogens bound to carbons which exists on both sides of the carbon exhibited almost the same chemical shift value. For this reason, the integrated value of such α-site hydrogen was obtained by dividing the integrated value of the methyl group hydrogens by three.

### (Production Example 5)

A 1-liter separable flask equipped with a thermometer, a stirring device and a reflux system was charged with 500 g of a polytetramethylene glycol manufactured by Asahi Kasei Corporation (number average molecular weight of 1,830; OH number 61.3) and 52.40 g of tolylene diisocyanate. The resultant mixture was reacted for about 3 hours under heating at 60°C, and then charged with 22.6 g of polyethylene glycol monomethacrylate (number average molecular weight: 360). This mixture was further made to react for about 2 hours, to thereby produce a resin (v) having a methacrylic group on a terminal (an average of about 2 polymerizable unsaturated groups in it's molecule per molecule) and whose number average molecular weight was about 20,000. This resin was like a starch syrup at 20°C, and flowed even if an external force was applied. In addition, it did not return to its original form when the external force was removed. The α-site hydrogen was the hydrogen atom at the site where the molecule terminal methacrylate ester bond was formed (value of chemical shift under ¹H-NMR: 4.1 to 4.2 ppm). From the integrated value of NMR measurement, the content of the α-site hydrogen was less than 2%.

### (Examples 1 to 9 and Comparative Examples 1 and 2)

Photosensitive resin compositions were prepared as a liquid resin (a) at 20°C using the resins (i) to (v) produced by the methods of Production Examples 1 to 5 by adding, as shown in Table 1, a polymerizable monomer; a porous micropowder silica manufactured by Fuji Silysia Chemical Ltd., i.e. tradenamed "Sylosphere C-1504" (hereinafter abbreviated as "C-1504"; number average particle diameter: 4.5 µm; specific surface area: 520 m²/g; average pore diameter: 12 nm; pore volume: 1.5 ml/g; ignition loss: 2.5% by weight; and oil absorption value: 290 ml/100 g), "Sylysia 450" (hereinafter abbreviated as "CH-450"; number average particle diameter: 8.0 µm; specific surface area: 300 m²/g; average pore diameter: 17 nm; pore volume: 1.25 ml/g; ignition loss: 5.0% by weight; and oil absorption value: 200 ml/100 g), and "Sylysia 470" (hereinafter abbreviated as "C-470"; number average particle diameter: 14.1 µm; specific surface area: 300 m²/g; average pore diameter: 17 nm; pore volume: 1.25 ml/g; ignition loss: 5.0% by weight; and oil absorption value: 180 ml/100 g); a photopolymerization initiator; and other additives.

The obtained resin composition was shaped into a sheet (thickness: 2.8 mm) on a PET (polyethylene terephthalate) film. The shaped resin article was exposed in air using an ALF model 200UP post-exposure apparatus (manufactured by Asahi Kasei Corporation), to thereby produce a sheet-like photosensitive resin cured product. The light used for exposure had 4,000 mJ/cm² and 12,000 mJ/cm² light from an ultraviolet fluorescent lamp (chemical lamp; central wavelength of 370 nm) and a germicidal lamp (central wavelength of 253 nm), respectively. The irradiated energy amount of the light from the ultraviolet fluorescent lamp was obtained from multiplying the luminance measured using a UV meter (tradename: "UV-M02"; manufactured by ORC Manufacturing Co., Ltd.) and a filter (tradename: "UV-35-APR filter"; manufactured by ORC Manufacturing Co., Ltd.) by the irradiated time. The measured luminance was the value at a position close to the surface of the photosensitive resin composition surface (within ±20 mm from the surface of the photosensitive resin composition surface).

As the used photopolymerization initiators, benzophenone (BP) was the hydrogen abstraction-type photopolymerization initiator (d), and 2,2-dimethoxy-2-phenylacetophene (DMPAP) was the disintegration-type photopolymerization initiator (e). Further, 2-benzyl-2-dimethylamino-1-(4-morpholinophenyl)-butanone (BDMB) was the photopolymerization initiator (c) having in the same molecule a site which functions as a hydrogen abstraction-type photopolymerization initiator and a site which functions as a disintegration-type photopolymerization initiator.
The photosensitive resin compositions of Examples 1 to 9 and Comparative Examples 1 and 2 were all liquid state at 20°C. Viscosity measured using a B-type viscometer was, at 20°C, between 200 Pa·s or more and 5 kPa·s or less in all the systems.

The surface tack of the produce sheet-like photosensitive resin cured products was, in all of the systems of Examples 1 to 9, 100 N/m or less. In the circumstances, their surfaces were completely cured. However, the surface of Comparative Example 1 was not completely cured, such that contacting with a finger left a fingerprint thereon. Further, in Comparative Example 2, although the surface vicinity was cured, the interior was not cured. In addition, the sticky liquid substance flowed out when pressed with a finger. Comparing Examples 5 to 8, the surface tack values of Example 5 was the smallest, the surface tack values of Example 6 was 30% higher than Example 5, the surface tack values of Example 7 was 60% higher than Example 5, and the surface tack values of Example 8 was 80% higher than Example 5.

The α-hydrogen atoms of the resin (a) used in Example 8 were the hydrogen atom at the site where the molecule terminal methacrylate ester bond was formed (value of chemical shift under ¹H-NMR: 4.1 to 4.2 ppm), the hydrogen atom at the site where the ester bond in the molecule chain was formed (value of chemical shift under ¹H-NMR: 4.1 to 4.2 ppm), and the hydrogen atom bound to the carbon to which the branched methyl group was bound (value of chemical shift under ¹H-NMR: 1.8 ppm). From the integrated value of NMR measurement, the content of the α-hydrogen atoms was 7.8%.
Of the organic compounds (b) used in the Examples of the present invention, the compounds containing an alicyclic group and an aromatic group were BZMA, CHMA and PEMA.
The evaluation of the laser engraving properties of the photosensitive resin cured products obtained in Examples 1 to 9 showed that the engraving residue in Examples 1 to 4 was a powder. The powder could be easily removed by a steam jet. However, as for Examples 5 to 9, the tack of the engraved surface after washing with a steam jet showed more than 200 N/m, and thus was large.

### (Example 10)

Using the same photosensitive resin composition as Example 1, a cylindrical photosensitive resin cured product was formed. Onto an air cylinder having diameter of 200 mm was fitted a 1.5 mm-thick sleeve made from glass fiber reinforced plastic whose inner diameter was the same. While rotating the air cylinder, the above-described photosensitive resin composition was coated onto the sleeve to a thickness of 3 mm using a doctor blade. Next, while rotating the air cylinder, light from an ultraviolet fluorescent lamp (chemical lamp; central wavelength of 370 nm) and light from a germicidal lamp (central wavelength of 253 nm) were respectively irradiated at 4,000 mJ/cm² and 12,000 mJ/cm², whereby a 3 mm -thick photosensitive resin cured product was obtained. The obtained photosensitive resin cured product was completely cured as far as its interior, and the surface tack was less than 100 N/m.

The irradiated energy amount of the light from the ultraviolet fluorescent lamp was obtained by multiplying the luminance measured using a UV meter (tradename: "UV-M02"; manufactured by ORC Manufacturing Co., Ltd.) and a filter (tradename: "UV-35-APR filter"; manufactured by ORC Manufacturing Co., Ltd.) by the irradiated time. The irradiated energy amount of the light from the germicidal lamp was obtained by multiplying the luminance measured using a UV meter (tradename: "UV-M02"; manufactured by ORC Manufacturing Co., Ltd.) and a filter (tradename: "UV-25-filter"; manufactured by ORC Manufacturing Co., Ltd.) by the irradiated time. The measured luminance was the value at a position close to the surface of the photosensitive resin composition (within ±20 mm from the surface of the photosensitive resin composition).

### (Example 11)

A 1 mm-thick cylindrical photosensitive resin composition was coated onto a sleeve in the same manner as in Example 10 using a photosensitive resin composition having the same composition as that of Example 3 except that it did not contain an inorganic porous body. Then, the photosensitive resin composition used in Example 1 was coated in a thickness of 3 mm, and light was irradiated thereon in an air atmosphere to form a photosensitive resin cured product having a bilayer structure. The surface of the obtained photosensitive resin cured product was confirmed to be completely cured, and further the cross-section which was provided by the cutting was also confirmed to be completely cured. The tack on the surface of the photosensitive resin cured product was less than 100 N/m.
In addition to the above-described photosensitive resin cured product, a photosensitive resin cured product was formed having the same thickness of 1 mm as the inner side layer. The Shore A hardness of this photosensitive resin cured product was measured at 55 degrees.

### (Example 12)

The photosensitive resin composition used when forming the inner side photosensitive resin cured product, which was used in Example 11, was strongly stirred in nitrogen gas, to thereby form tiny air bubbles in the photosensitive resin composition. The thus-obtained photosensitive resin composition was coated onto a sleeve made from glass fiber reinforced plastic in a thickness of 0.5 mm in the same manner as in Example 10, and then cured by irradiating with light in an air atmosphere. The obtained photosensitive resin cured product surface and interior were completely cured.

**Table 1**

| | Resin (a) | | Organic Compound (b) | | Inorganic Porous Body | | Polymerization Initiator | | Other Additives | |
|---|---|---|---|---|---|---|---|---|---|---|
| | Type | Blend Amount | Type | Blend Amount | Type | Blend Amount | Type | Blend Amount | Type | Blend Amount |
| Example 1 | (i) | 100 | BZMA | 25 | C-1504 | 5 | DMPAP | 0.6 | BHT | 0.5 |
| | | | CHMA | 19 | | | BP | 1 | | |
| | | | BDEGMA | 6 | | | | | | |
| Example 2 | (ii) | 100 | as above | | CH-450 | 5 | as above | | as above | |
| Example 3 | (iii) | 100 | as above | | C-470 | 5 | as above | | as above | |
| Example 4 | (i) | 100 | LMA | 6 | C-1504 | 5 | as above | | as above | |
| | | | PPMA | 15 | | | | | | |
| | | | DEEHEA | 25 | | | | | | |
| | | | TEGDMA | 2 | | | | | | |
| | | | TMPTMA | 2 | | | | | | |
| Example 5 | (i) | 100 | BZMA | 25 | none | | DMPAP | 0.6 | BHT | 0.5 5 |
| | | | CHMA | 19 | | | BP | 1.5 | LB | 5 |
| | | | BDEGMA | 6 | | | | | | |
| Example 6 | (iii) | 100 | as above | | none | | as above | | as above | |
| Example 7 | (iv) | 100 | as above | | none | | as above | | as above | |
| Example 8 | (iv) | 50 | as above | | none | | as above | | as above | |
| | (i) | 50 | | | | | | | | |
| Comparative Example 1 | (i) | 100 | as above | | none | | DMPAP | 1.6 | as above | |
| Comparative Example 2 | (i) | 100 | as above | | none | | BP | 1.6 | as above | |
| Example 9 | (i) | 100 | as above | | none | | BDMB | 1.0 | as above | |

| | | | | | | | | | | |
|---|---|---|---|---|---|---|---|---|---|---|
| Units for the Blend Amount in the Table: parts by weight (Explanation of abbreviations) LMA: Lauryl methacrylate (Mn254) PPMA: polypropylene glycol monomethacrylate (Mn400) DEEHEA: diethylen glycol-2-ethylhexylmethacrylate (Mn286) TEGDMA: tetraethylene glycol dimethacrylate (Mn330) TMPTMA: trimethylolpropane trimethacrylate (Mn339) BZMA: benzyl methacrylate (Mn176) CHMA: cyclohexyl methacrylate (Mn167) BDEGMA: butoxydiethylene glycol methacrylate (Mn230) PEMA: phenoxyethyl methacrylate (Mn206) DMPAP: 2,2-dimethoxy-2-phenylacetophenone BP: benzophenone BDMB: 2-benzyl-2-dimethylamino-1-(4-morpholinophenyl)-butanone BHT: 2,6-di-t-butylacetophenone LB: Lauric acid-n-butyl | | | | | | | | | | |

### INDUSTRIAL APPLICABILITY

The present invention can be suitably applied in fields relating to the production of a photosensitive resin composition which can be photo-cured in air and a photosensitive resin cured product.

## Claims

1. A process for producing a laser engravable and cylindrical printing base material comprising the steps of: forming a photosensitive resin composition layer of from 50 µm up to 50 mm in thickness on a cylindrical support using a photosensitive resin composition which comprises a hydrogen abstraction-type photopolymerization initiator (d) and a disintegration-type photopolymerization initiator (e) wherein the hydrogen abstraction-type photopolymerization initiator (d) is at least one kind of compound selected from the group consisting of benzophenones, Michler's ketones, xanthenes, thioxanthenes and anthraquinones, and the disintegration-type photopolymerization initiator (e) is at least one kind of compound selected from the group consisting of benzoin alkyl ethers, 2,2-dialkoxy-2-phenylacetophenones, acyloxime esters, azo compounds and diketones, or a photosensitive resin composition which comprises a photopolymerization initiator (c) having in the same molecule a site which functions as a hydrogen abstraction-type photopolymerization initiator and a site which functions as a disintegration-type photopolymerization initiator; and curing by irradiating the photosensitive resin composition layer with light in air.

2. The process for producing a laser engravable and cylindrical printing base material according to Claim 1, wherein the photosensitive resin composition is a liquid state at 20°C.

3. The process for producing a laser engravable and cylindrical printing base material according to Claim-1 or 2, wherein the photosensitive resin composition layer is formed by coating the photosensitive resin composition onto a cylindrical support.

4. Use of a laser engravable and cylindrical printing base material obtained by the process according to any of Claims 1 to 3, as a transfer roll (blanket roll) for transferring ink, an ink squeeze roll in contact with an anilox roll for adjusting an ink supply, a roll used for laser engraving which can form an uneven pattern on a surface by laser engraving, or a cushion roll.

5. A photosensitive resin composition for a laser engravable and cylindrical printing base material comprising
a resin (a) having a number average molecular weight of from 1,000 or more to 200,000 or less, wherein the resin (a) comprises in a molecule thereof either at least one kind of organic group selected from the group consisting of an aryl group, a straight or branched chain alkyl group substituted with at least one aryl group, an alkoxycarbonyl group, a hydroxyl group
and a formyl group or a bond of a carbonate bond or an ester bond; the organic group and the bond directly bind to a carbon atom; the carbon atom binds to hydrogen atom(s) (α-hydrogen atom(s)) of no less than 2% with respect to the total of hydrogen atoms in the molecule;
an organic compound (b) having a number average molecular weight of from 1,000 or less and a polymerizable unsaturated group; and
a photopolymerisation initiator wherein the photopolymerization initiator is a combination of a hydrogen abstraction-type photopolymerization initiator (d) and a disintegration-type photopolymerization initiator (e) wherein the hydrogen abstraction-type photopolymerization initiator (d) is at least one kind of compound selected from the group consisting of benzophenones, Michler's ketones, xanthenes, thioxanthenes and anthraquinones, and the disintegration-type photopolymerization initiator (a) is at least one kind of compound selected from the group consisting of benzoin alkyl ethers, 2,2-dialkoxy-2-phenylacetophenones, acyloxime esters, azo compounds and diketones, the hydrogen abstraction-type photopolymerization initiator (d) and the disintegration-type photopolymerization initiator (e), are respectively 0.3% or more with respect to the total weight of the photosensitive resin composition.

6. The photosensitive resin composition for a laser engravable and cylindrical printing base material according to Claim 5, wherein resin (a) is a liquid state at 20°C.

7. The photosensitive resin composition for a laser engravable and cylindrical printing base material according to any one of Claims 5 and 6, further comprising at least one kind of microparticles selected from the group consisting of inorganic microparticles, organic microparticles and organic-inorganic composite microparticles.

8. A laser engravable printing base material obtained by forming the photosensitive resin composition for a laser engravable and cylindrical printing base material according to any one of Claims 5 to 7 into a sheet form or a cylindrical form, then curing by irradiating with light in air.

9. A multilayer printing base material, wherein the printing base material according to Claim 8 comprises, on a lower portion, at least one layer of an elastomer layer having either a Shore A hardness of from 10 degrees up to 70 degrees or an ASKER-C hardness of from 20 degrees up to 85 degrees.

10. The laser engravable multilayer printing base material according to Claim 9, wherein the elastomer layer is formed by curing a laser engravable photosensitive resin composition which is a liquid state at 20°C.

11. The process for producing a laser engravable and cylindrical printing base material according to Claim 1, wherein the photosensitive resin composition has a viscosity between 10 Pa·s and 10 kPa·s at 20°C.

12. The photosensitive resin composition for a laser engravable and cylindrical printing base material according to Claim 5, wherein the resin (a) comprises the organic group and the bond directly bind to a carbon atom; the carbon atom binds to hydrogen atom(s) (α-hydrogen atom(s)) of no less than 10% with respect to the total of hydrogen atoms in the molecule.

## Patentansprüche

1. Verfahren zur Herstellung eines Laser-gravierbaren und zylindrischen Druckbasismaterials, mit den Schritten: Bilden einer Schicht einer fotosensitiven Harzzusammensetzung mit 50 µm bis 50 mm Dicke auf einem zylindrischen Träger unter Verwendung einer fotosensitiven Harzzusammensetzung, welche einen Fotopolymerisationsinitiator vom Wasserstoffabstraktionstyp (d) und einen Fotopolymerisationsinitiator vom Zerfallstyp (e) enthält, wobei der Fotopolymerisationsinitiator vom Wasserstoffabstraktionstyp (d) mindestens eine Verbindungsart ist, ausgewählt aus der Gruppe, bestehend aus Benzophenonen, Michlers Ketonen, Xanthenen, Thioxanthenen und Anthrachinonen, und der Fotopolymerisationsinitiator vom Zerfallstyp (e) mindestens eine Verbindungsart ist, ausgewählt aus der Gruppe, bestehend aus Benzoinalkylethern, 2,2-Dialkoxy-2-phenylacetophenonen, Acyloximestern, Azoverbindungen und Diketonen, oder einer fotosensitiven Harzzusammensetzung, welche einen Fotopolymerisationsinitiator (c) enthält, welcher in dem gleichen Molekül eine Stelle aufweist, welche als Fotopolymerisationsinitiator vom Wasserstoffabstraktionstyp wirkt, und eine Stelle, welche als Fotopolymerisationsinitiator vom Zerfallstyp wirkt; und Härten durch Bestrahlen der Schicht einer fotosensitiven Harzzusammensetzung mit Licht an Luft.

2. Verfahren zur Herstellung eines Laser-gravierbaren und zylindrischen Druckbasismaterials nach Anspruch 1, worin die fotosensitive Harzzusammensetzung bei 20°C in einem flüssigen Zustand ist.

3. Verfahren zur Herstellung eines Laser-gravierbaren und zylindrischen Druckbasismaterials nach Anspruch 1 oder 2, worin die fotosensitive Harzzusammensetzungsschicht durch Schichten der fotosensitiven Harzzusammensetzung auf einen zylindrischen Träger gebildet wird.

4. Verwendung eines durch das Verfahren nach einem der Ansprüche 1 bis 3 erhaltenen Laser-gravierbaren und zylindrischen Druckbasismaterials als Übertragungswalze (Auftragswalze) zur Übertragung von Druckfarbe, als Druckfarbenpresswalze in Kontakt mit einer Anilox-Walze zur Einstellung einer Druckfarbenzufuhr, als eine zum Lasergravieren verwendete Walze, welche durch Lasergravieren ein unebenes Muster auf einer Oberfläche bilden kann, oder als eine Dämpfungswalze.

5. Fotosensitive Harzzusammensetzung für ein Laser-gravierbares und zylindrisches Druckbasismaterial, mit:
einem Harz (a) mit einem Zahlenmittel des Molekulargewichts von 1000 oder mehr bis 200000 oder weniger, worin das Harz (a) in einem Molekül davon mindestens eine Art einer organischen Gruppe enthält, ausgewählt aus der Gruppe, bestehend aus einer Arylgruppe, einer geraden oder verzweigtkettigen Alkylgruppe, mit mindestens einer Arylgruppe substituiert ist, einer Alkoxycarbonylgruppe, einer Hydroxygruppe und einer Formylgruppe oder einer Carbonatbindung oder einer Esterbindung; wobei die organische Gruppe und die Bindung direkt an ein Kohlenstoffatom binden; das Kohlenstoffatom an (ein) Wasserstoffatom(e) (α-Wasserstoffatom(e)) von nicht weniger als 2% bezüglich der gesamten Wasserstoffatome in dem Molekül bindet;
einer organischen Verbindung (b) mit einem Zahlenmittel des Molekulargewichts von 1000 oder weniger und einer polymerisierbaren ungesättigten Gruppe; und
einem Fotopolymerisationsinitiator, worin der Fotopolymerisationsinitiator eine Kombination eines Fotopolymerisationsinitiators vom Wasserstoffabstraktionstyp (d) und einem Fotopolymerisationsinitiators vom Zerfallstyp (e) ist, worin der Fotopolymerisationsinitiator vom Wasserstoffabstraktionstyp (d) mindestens eine Verbindungsart ist, ausgewählt aus der Gruppe, bestehend aus Benzophenonen, Michlers Ketonen, Xanthenen, Thioxanthenen und Anthrachinone, und der Fotopolymerisationsinitiator vom Zerfallstyp (e) mindestens eine Verbindungsart ist, ausgewählt aus der Gruppe, bestehend aus Benzoinalkylethern, 2,2-Dialkoxy-2-phenylacetophenonen, Acyloximestern, Azoverbindungen und Diketonen, wobei der Fotopolymerisationsinitiator vom Wasserstoffabstraktionstyp (d) und der Fotopolymerisationsinitiator vom Zerfallstyp (e) jeweils 0,3 % oder mehr in Bezug auf das Gesamtgewicht der fotosensitiven Harzzusammensetzung betragen.

6. Fotosensitive Harzzusammensetzung für ein Laser-gravierbares und zylindrisches Druckbasismaterial nach Anspruch 5, worin das Harz (a) bei 20°C in einem flüssigen Zustand ist.

7. Fotosensitive Harzzusammensetzung für ein Laser-gravierbares und zylindrisches Druckbasismaterial nach einem der Ansprüche 5 und 6, welche weiterhin eine Art von Mikroteilchen enthält, ausgewählt aus der Gruppe, bestehend aus anorganischen Mikroteilchen, organischen Mikroteilchen und organischanorganischen Verbundmikroteilchen.

8. Laser-gravierbares Druckbasismaterial, erhältlich durch Formen der fotosensitiven Harzzusammensetzung für ein Laser-gravierbares und zylindrisches Druckbasismaterial nach einem der Ansprüche 5 bis 7 zu einer Plattenform oder einer zylindrischen Form und anschließend Härten durch Bestrahlen mit Licht an Luft.

9. Mehrschichtiges Druckbasismaterial, worin das Druckbasismaterial nach Anspruch 8 auf einem unteren Bereich mindestens eine Schicht einer Elastomerschicht mit entweder einer Shore A-Härte von 10 Grad bis 70 Grad oder einer ASKER-C-Härte von 20 Grad bis zu 85 Grad aufweist.

10. Laser-gravierbares, mehrschichtiges Druckbasismaterial nach Anspruch 9, worin die Elastomerschicht durch Härten einer Laser-gravierbaren fotosensitiven Harzzusammensetzung, welche bei 20°C in einem flüssigen Zustand ist, gebildet ist.

11. Verfahren zur Herstellung eines Laser-gravierbaren und zylindrischen Druckbasismaterials nach Anspruch 1, worin die fotosensitive Harzzusammensetzung bei 20°C eine Viskosität zwischen 10 Pa·s und 10 kPa·s aufweist.

12. Fotosensitive Harzzusammensetzung für ein Laser-gravierbares und zylindrisches Druckbasismaterial nach Anspruch 5, worin das Harz (a) die direkt an ein Kohlenstoffatom gebundene organische Gruppe und Bindung aufweist; und das Kohlenstoffatom an Wasserstoffatom(e) (α-Wasserstoffatom(e)) von nicht weniger als 10 % in Bezug auf die gesamten Wasserstoffatome in dem Molekül bindet.

## Revendications

1. Procédé pour produire un matériau de base d'impression susceptible de gravure laser et cylindrique comprenant les étapes de :
former une couche de composition de résine photosensible de 50 µm à 50 mm d'épaisseur sur un support cylindrique avec une composition de résine photosensible qui comprend un initiateur de photopolymérisation du type à retrait d'hydrogène (d) et un initiateur de photopolymérisation du type à désintégration (e) où l'initiateur de photopolymérisation du type à retrait d'hydrogène (d) est au moins un type de composé choisi dans le groupe consistant en les benzophénones, les cétones de Michler, les xanthènes, les thioxanthènes et les anthraquinones et l'initiateur de photopolymérisation du type à désintégration (e) est au moins un type de composé choisi dans le groupe consistant en les alkyléthers de benzoïne, les 2,2-dialcoxy-2-phénylacétophénones, les esters acyloximes, les composés azoïques et les dicétones, ou une composition de résine photosensible qui comprend un initiateur de photopolymérisation (c) ayant dans la même molécule un site qui joue le rôle d'initiateur de photopolymérisation du type à retrait d'hydrogène et un site qui joue le rôle d'initiateur de photopolymérisation du type à désintégration ; et durcir par irradiation la couche de composition de résine photosensible avec de la lumière dans l'air.

2. Procédé pour produire un matériau de base d'impression susceptible de gravure laser et cylindrique selon la revendication 1 où la composition de résine photosensible est à l'état liquide à 20°C.

3. Procédé pour produire un matériau de base d'impression susceptible de gravure laser et cylindrique selon la revendication 1 ou 2, où la couche de composition de résine photosensible est formée par application de la composition de résine photosensible en revêtement sur un support cylindrique.

4. Utilisation d'un matériau de base d'impression susceptible de gravure laser et cylindrique obtenu par le procédé selon l'une quelconque des revendications 1 à 3 comme rouleau preneur (rouleau de blanchet) pour transférer de l'encre, rouleau essoreur d'encre en contact avec un rouleau anilox pour ajuster un apport d'encre, rouleau utilisé pour la gravure laser qui peut former un motif non uniforme sur une surface par une gravure laser, ou rouleau amortisseur.

5. Composition de résine photosensible pour matériau de base d'impression susceptible de gravure laser et cylindrique comprenant :
une résine (a) ayant une masse moléculaire moyenne en nombre de 1 000 ou plus à 200 000 ou moins, où la résine (a) comprend dans une molécule de celle-ci au moins un type de groupe organique choisi dans le groupe consistant en un groupe aryle, un groupe alkyle linéaire ou ramifié substitué avec au moins un groupe aryle, un groupe alcoxycarbonyle, un groupe hydroxyle, et un groupe formyle ou une liaison d'une liaison carbonate ou d'une liaison ester ; le groupe organique et la liaison étant liés directement à un atome de carbone ; l'atome de carbone étant lié à un ou des atomes d'hydrogène (atome(s) d'hydrogène α) à raison d'au moins 2 % par rapport au total des atomes d'hydrogène dans la molécule ;
un composé organique (b) ayant une masse moléculaire moyenne en nombre de 1 000 ou moins et un groupe insaturé polymérisable ; et
un initiateur de photopolymérisation où l'initiateur de photopolymérisation est une combinaison d'un initiateur de photopolymérisation du type à retrait d'hydrogène (d) et d'un initiateur de photopolymérisation du type à désintégration (e) où l'initiateur de photopolymérisation du type à retrait d'hydrogène (d) est au moins un type de composé choisi dans le groupe consistant en les benzophénones, les cétones de Michler, les xanthènes, les thioxanthènes et les anthraquinones et l'initiateur de photopolymérisation du type à désintégration (e) est au moins un type de composé choisi dans le groupe consistant en les alkyléthers de benzoïne, les 2,2-dialcoxy-2-phénylacétophénones, les esters acyloximes, les composés azoïques et les dicétones, l'initiateur de photopolymérisation du type à retrait d'hydrogène (d) et l'initiateur de photopolymérisation du type à désintégration (e) représentent respectivement 0,3 % ou plus par rapport à la masse totale de la composition de résine photosensible.

6. Composition de résine photosensible pour matériau de base d'impression susceptible de gravure laser et cylindrique selon la revendication 5 où la résine (a) est à l'état liquide à 20°C.

7. Composition de résine photosensible pour matériau de base d'impression susceptible de gravure laser et cylindrique selon l'une quelconque des revendications 5 et 6 comprenant en outre au moins un type de microparticules choisies dans le groupe consistant en les microparticules inorganiques, les microparticules organiques et les microparticules composites organiques-inorganiques.

8. Matériau de base d'impression susceptible de gravure laser obtenu en mettant la composition de résine photosensible pour matériau de base d'impression susceptible de gravure laser et cylindrique selon l'une quelconque des revendications 5 à 7 sous forme de feuille ou sous forme cylindrique, puis en durcissant par irradiation avec de la lumière dans l'air.

9. Matériau de base d'impression multicouche où le matériau de base d'impression selon la revendication 8 comprend, sur une partie inférieure, au moins une couche d'une couche d'élastomère ayant une dureté Shore A de 10 degrés à 70 degrés ou une dureté ASKER-C de 20 degrés à 85 degrés.

10. Matériau de base d'impression multicouche susceptible de gravure laser selon la revendication 9 où la couche d'élastomère est formée par durcissement d'une composition de résine photosensible susceptible de gravure laser qui est à l'état liquide à 20°C.

11. Procédé pour produire un matériau de base d'impression susceptible de gravure laser et cylindrique selon la revendication 1 où la composition de résine photosensible a une viscosité entre 10 Pa.s et 10 kPa.s à 20°C.

12. Composition de résine photosensible pour matériau de base d'impression susceptible de gravure laser et cylindrique selon la revendication 5 où la résine (a) comprend le groupe organique et la liaison liés directement à un atome de carbone ; l'atome de carbone est lié à un ou des atomes d'hydrogène (atome(s) d'hydrogène α) à raison d'au moins 10 % par rapport au total des atomes d'hydrogène dans la molécule.
